# EUROPÄISCHE PATENTSCHRIFT

(11) **EP 0 388 585 B1**
(45) Veröffentlichungstag und Bekanntmachung des Hinweises auf die Patenterteilung: **21.12.1994**
(21) Anmeldenummer: 90101057.9
(22) Anmeldetag: 19.01.1990
(51) Int. Cl.: H01R 13/66, H01R 4/66

(54) **Schutzstecker für Anschlussleisten der Fernmelde- und Datentechnik**
Protection connector for a communication and data technique connecting block
Connecteur de protection pour barrette de connexion pour technique de télécommunication et de traitement de données

(30) Priorität: 22.03.1989 DE 3909783
(43) Veröffentlichungstag der Anmeldung: 26.09.1990
(73) Patentinhaber: KRONE Aktiengesellschaft, D-14167 Berlin (DE)
(72) Erfinder: Hegner, Gunter, D-1000 Berlin 27 (DE); Achtnig, Klaus-Peter, D-1000 Berlin 45 (DE)

(56) Entgegenhaltungen:
- EP-A- 0 180 729
- DE-A- 3 840 198
- DE-C- 3 644 349
- DE-C- 3 726 741
- US-A- 4 113 340

## Beschreibung

Die Erfindung bezieht sich auf einen Schutzstecker für Anschlußleisten der Fernmelde- und Datentechnik gemäß dem Oberbegriff des Anspruches 1.

Ein Schutzstecker für Anschlußleisten der gattungsgemäßen Art ist aus der DE-C-37 26 741 vorbekannt. In dieser Anschlußleiste sind in zwei Reihen hintereinander dicht an dicht angeordnete Schneid-Klemm-Kontakte vorgesehen, die zum Anschluß von isolierten Kabeladern dienen. Zum Schutz vor Überspannungen ist für jede Doppelader ein Schutzstecker von oben zwischen den beiden Reihen von Schneid-Klemm-Anschlußkontakten einsteckbar. Der Schutzstecker weist hierzu eine aus dem Gehäuse herausragende Steckerzunge auf, die in einen Abgriff eingesteckt wird, der mit jeweils einem Schneid-Klemm-Kontakt jeder Reihe verbunden ist. Hierdurch wird eine elektrische Verbindung von den Schneid-Klemm-Kontakten zu einem im Gehäuse des Schutzsteckers angeordneten Überspannungsableiter hergestellt. Die Erdverbindung vom Überspannungsableiter zu einer außerhalb der Anschlußleiste verlaufenden Erdschiene wird mittels eines Gabelkontaktes hergestellt. Aufgrund der räumlich begrenzten Möglichkeiten ist bei einer derartigen Anordnung von dicht an dicht angeordneten Schutzsteckern nur ein Schutz gegen Überspannungen möglich.

Der Erfindung liegt von daher die Aufgabe zugrunde, einen Schutzstecker der gattungsgemäßen Art zu schaffen, bei dem zusätzlich zum Überspannungsschutz ein Stromschutz vorgesehen ist, ohne die baulichen Abmessungen, insbesondere die Höhe des Schutzsteckers zu vergrößern.

Die Lösung dieser Aufgabe ergibt sich aus den kennzeichnenden Merkmalen des Anspruches 1. Erfindungsgemäß wird durch die im Gehäuse angeordnete Leiterplatte erreicht, daß beidseitig der Leiterplatte Schutzelemente mit verschiedenen Schutzfunktionen einsetzbar sind, ohne daß sich die äußeren Abmessungen, insbesondere die Höhe, des Schutzsteckers vergrößern. Somit wird erreicht, daß trotz der dicht an dicht angeordneten Schutzstecker und des geringen Bauraums innerhalb eines Gehäuses ein Schutz vor Überspannungen und eine Sicherung gegen Überströme ausgebildet werden kann.

Weitere vorteilhafte Ausgestaltungen der Erfindung ergeben sich aus den Unteransprüchen. So bewirken die gemäß den Ansprüchen 5 und 6 ausgebildeten Leiterplatten, daß ohne Veränderung der baulichen Anordnung der Schutzelemente verschiedene Schutzfunktionen erzielt werden können. So ist gemäß Anspruch 5 der Stromschutz auf der Linienseite und gemäß Anspruch 6 auf der Amtsseite möglich.

Gemäß Anspruch 7 sind nach dem Ziehen eines Schutzsteckers aus einer Reihe von mehreren nebeneinander dicht an dicht angeordneten Schutzsteckern die an den Schneid-Klemm-Kontakten angeschlossenen Kabeladern zugänglich. Auch können Kabeladern mittels eines Werkzeuges an die Schneid-Klemm-Kontakte angeschlossen werden, ohne daß die noch gesteckten Schutzstecker das Werkzeug beim Anschalten behindern.

Die Erfindung ist nachfolgend anhand eines in den Zeichnungen näher dargestellten Ausführungsbeispieles eines Schutzsteckers für Anschlußleisten näher erläutert.

Es zeigen:
- Fig. 1: einen Querschnitt durch die Anschlußleiste und den aufgesteckten Schutzstecker,
- Fig. 2: eine Draufsicht auf mehrere, in zwei Reihen angeordneten Anschlußleisten und aufgesteckte Schutzstecker,
- Fig. 3: einen vergrößerten Querschnitt durch den Schutzstecker,
- Fig. 4: einen Längsschnitt durch den Schutzstecker gemäß der Linie IV-IV in Fig. 3,
- Fig. 5: die Draufsicht auf den Schutzstecker,
- Fig. 6: die Vorderansicht einer Leiterplatte des Schutzsteckers in der ersten Ausführung,
- Fig. 7: die Rückansicht der Leiterplatte nach Fig. 6,
- Fig. 8: die Vorderansicht einer Leiterplatte des Schutzsteckers in der zweiten Ausführung,
- Fig. 9: die Rückansicht der Leiterplatte nach Fig. 8,
- Fig. 10: das Schaltungsbild der Leiterplatte gemäß den Figuren 6 und 7,
- Fig. 11: das Schaltungsbild der Leiterplatte gemäß den Figuren 8 und 9,
- Fig. 12: eine Seitenansicht des Spannungsbegrenzers,
- Fig. 13: die Vorderansicht nach Fig. 12 und
- Fig. 14: die Rückansicht nach Fig. 12.

Der Schutzstecker 1 besteht aus einem Gehäuse 2, das aus zwei miteinander verrasteten Gehäusehälften 3 gebildet ist, aus einer im Gehäuse 2 angeordneten, eine Steckerzunge 5 bildenden Leiterplatte 4, einem Spannungsbegrenzer 7, zwei Stromsicherungen 8,9 und einen Erdkontakt 40. Das aus Kunststoff hergestellte Gehäuse 2 ist im wesentlichen als quaderförmiger Gehäusekörper ausgebildet und weist an seiner Unterseite 15 zwei Gehäuseöffnungen 16,17 auf.

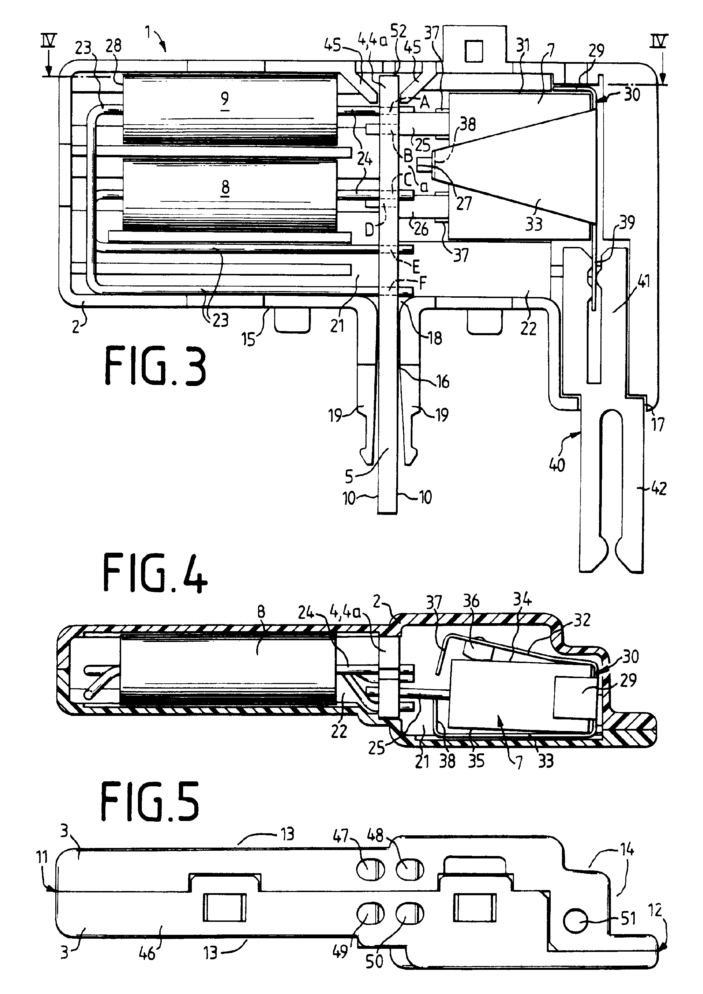

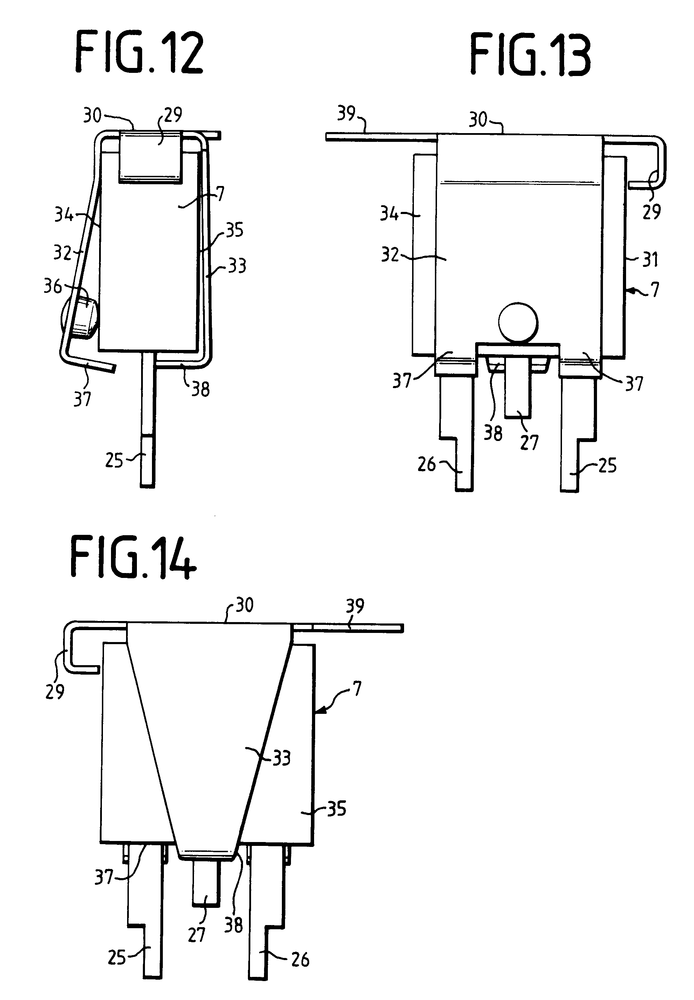

Die schlitzförmige Gehäuseöffnung 16 dient zur Durchführung der im Gehäuse 2 fixierten Leiterplatte 4, deren nach außen geführtes Ende freistehend aus dem Gehäuse 2 herausragt und die Steckerzunge 5 bildet. Die schlitzförmige Gehäuseöffnung 16 ist ungefähr im mittleren Bereich der Unterseite 15 des Gehäuses 2 vorgesehen und besitzt am Schlitzrand 18 zwei Rasthaken 19, die zur Rastverbindung des Schutzsteckers 1 mit einer Anschlußleiste 20 vorgesehen sind. Die Leiterplatte 4 ist ferner zwischen den beidseitig anliegenden Rasthaken 19 geführt und abgestützt. Am anderen Ende 52 der Leiterplatte 4 sind im Gehäuse 2 Stützhaken 45 vorgesehen, die die Leiterplatte 4 beidseitig abstützen und festlegen. Die Leiterplatte 4 ist somit im wesentlichen mittig innerhalb des Gehäuses 2 angeordnet und teilt den Innenraum des Gehäuses 2 in zwei Gehäuseräume 21 und 22 auf. Im ersten Gehäuseraum 21 sind zwei Stromsicherungen 8,9 angeordnet, die mit ihren Anschlußbeinen 23,24 in Anschlußpunkten A,F und C,E eingesteckt sind. Im zweiten Gehäuseraum 22 ist ein Spannungsbegrenzer 7 angeordnet, der mit seinen Anschlußbeinen 25,26 in die Anschlußpunkte B,D der Leiterplatte 4 eingesteckt ist. Da die Stromsicherungen 8,9 ihre beiden Anschlußbeine 23,24 auf zwei entgegengesetzten Seitenflächen 28 aufweisen, sind die Anschlußbeine 23 der Stromsicherungen 8,9 länger ausgebildet und zweimal um 90° abgebogen, so daß die Enden aller Anschlußbeine 23,24 der Stromsicherungen 8,9 in die gleiche Richtung zeigen. Der im zweiten Gehäuseraum 22 aufgenommene und in den Figuren 12, 13 und 14 dargestellte Spannungsbegrenzer 7, z.B. ein sogenanter Solid-State-Protector, besteht aus einem plattenförmigen Gehäusekörper und besitzt an einer Gehäuseseite drei Anschlußbeine 25,26,27, die in einer Reihe angeordnet sind. Das mittlere Anschlußbein 27 ist hierbei gekürzt, so daß ein Abstand a zwischen dem Ende des Anschlußbeines 27 und der Leiterplatte 4 besteht, wie es insbesondere in Figur 3 dargestellt ist. Über dem Spannungsbegrenzer 7 ist eine metallische Klammer 30 als Thermoschutz befestigt. Die Klammer 30 ist im Querschnitt im wesentlichen U-förmig ausgebildet und besitzt seitliche Blechlappen 29, die um 90° abgebogen an den Seitenflächen 31 des Spannungsbegrenzers 7 anliegen. Die Schenkel 32,33 der U-förmigen Klammer 30 liegen an der Vorder- und Rückseite 34,35 des Spannungsbegrenzers 7 an. Die Enden der Schenkel 32,33 sind um ca. 90° abgebogen und bilden federnde Kontaktelemente 37,38, die zur Verbindung mit den Anschlußbeinen 25,26,27 dienen. Der an der Rückseite 35 anliegende Schenkel 33 ist trapezförmig ausgebildet, so daß das federnde Kontaktelement 38 mit dem mittleren Anschlußbein 27 in Berührung steht, ohne die Anschlußbeine 25,26 zu berühren. Der Schenkel 32 der Klammer 30 wird dagegen durch ein an ihm befestigtes Schmelzelement 36 zur Vorderseite 34 auf Abstand gehalten, so daß auch die Kontaktelemente 37 zu den Anschlußbeinen 25,26 auf Abstand stehen. An der Klammer 30 ist eine Kontaktzunge 39 vorgesehen, die in einen Gabelkontakt 41 des Erdkontaktes 40 eingesteckt ist. Der Erdkontakt 40 besteht aus einem metallischen Blechstreifen, an dessen Enden jeweils ein Gabelkontakt 41,42 ausgebildet ist. Der Gabelkontakt 41 ist innerhalb und der Gabelkontakt 42 außerhalb des Gehäuses 2 angeordnet, wobei der Erdkontakt 40 in der schlitzförmigen Gehäuseöffnung 17 aufgenommen und gehalten ist.

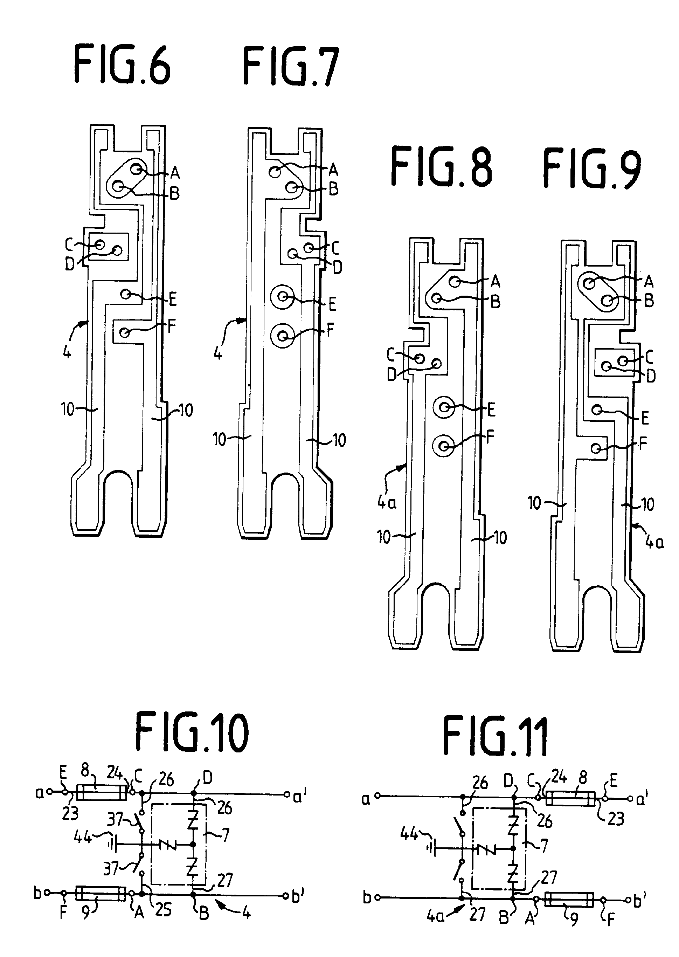

Für unterschiedliche Schutzfunktionen ist entweder eine erste Leiterplatte 4 oder eine zweite Leiterplatte 4a in das Gehäuse 2 eingesetzt. Beide Leiterplatten 4,4a weisen gleiche Anschlußpunkte A bis F auf. Sie unterscheiden sich jedoch durch andere Druckbilder der Leiterbahnen. Die Leiterplatte 4 ist in den Figuren 6 und 7, das dazugehörige Schaltungsbild in Fig. 10 dargestellt. Die Leiterplatte 4a ist in den Figuren 8 und 9, das dazugehörige Schaltungsbild in Figur 11 dargestellt.

Um den Stromschutz vor dem Überspannungsschutz (Sicherung der Linienseite) einzusetzen, ist die Leiterplatte 4 gemäß den Figuren 6,7,10 zu verwenden. Das Schaltungsbild gemäß Fig. 10 zeigt links die linienseitigen Anschlüsse a und b der Kabeladern und rechts die amtsseitigen Anschlüsse a′ und b′. Des weiteren ist im Schaltungsbild dargestellt, daß die Stromsicherung 8 an den Anschlußpunkten E und C und die Stromsicherung 9 an den Anschlußpunkten A und F angeschlossen sind. Der Spannungsbegrenzer 7 ist an den Anschlußpunkten D und B angeschlossen. Bei diesem Schaltungsbild wird die a-Ader am Anschlußpunkt E angeschlossen, die b-Ader am Anschlußpunkt F, die a′-Ader am Anschlußpunkt D und die b′-Ader am Anschlußpunkt B.

Ist ein Stromschutz hinter dem Überspannungsschutz gefordert (Sicherung der Amtsseite), so ist die Leiterplatte 4a gemäß den Figuren 8, 9 und 11 zu verwenden. Wie das Schaltungsbild gemäß Figur 11 zeigt, sind links die linienseiten Anschlüsse a und b und rechts die amtsseitigen Anschlüsse a′,b′ für die Kabeladern dargestellt. Auch hier ist die Stromsicherung 8 an den Anschlußpunkten C und E und die Stromsicherung 9 an den Anschlußpunkten A und F angeschlossen. Der Strombegrenzer 7 ist ebenfalls an den Anschlußpunkten B und D angeschlossen. Im Gegensatz zur erstgenannten Leiterplatte 4 werden bei der Leiterplatte 4a jedoch die Kabelader a am Anschlußpunkt D, die Kabelader b am Anschlußpunkt B, die Kabelader a′ am Anschlußpunkt E und die Kabelader b′ am Anschlußpunkt F angeschlossen.

Diese unterschiedlichen Schaltungen der Schutzelemente 6 ergeben sich aus den unterschiedlichen Druckbildern der Leiterbahnen 10 gemäß den Figuren 6, 7, 8 und 9.

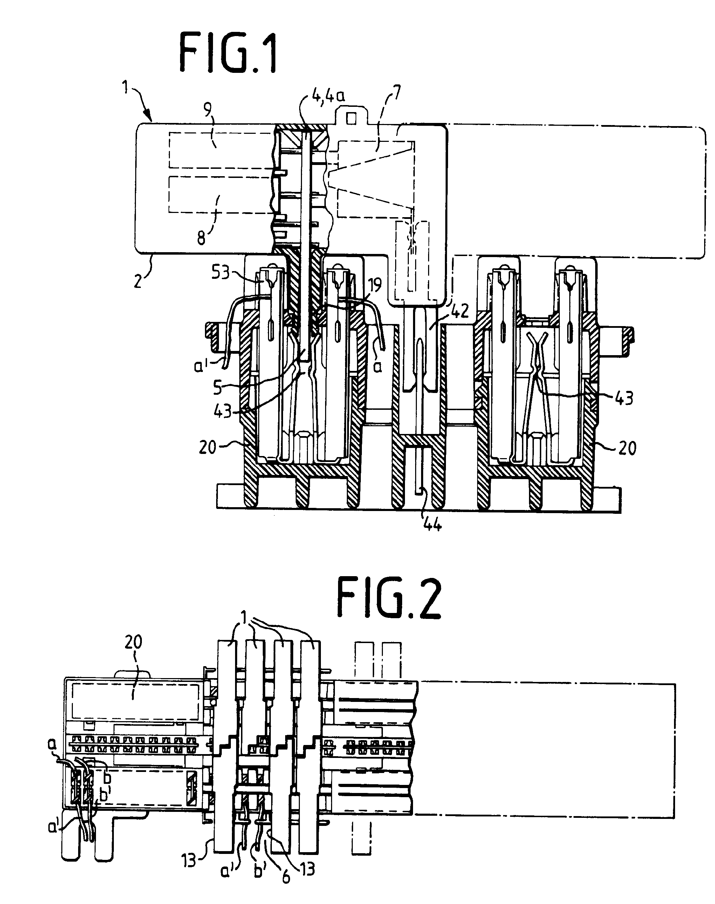

Der Schutzstecker 1 wird zum Ableiten von Überspannungen und zur Sicherung gegen Überströme zwischen den Kabeladern a,b und a′,b′ in den Trennkontakt 43 einer Anschlußleiste 20 eingesteckt. Anstelle von Trennkontakten 43 können auch nicht dargestellte Arbeitskontakte in die Anschlußleiste 20 eingesetzt werden. Die Anschlußleiste 20 weist zwei Reihen von Schneid-Klemm-Kontakten 42 auf, wobei zwei gegenüberliegende Schneid-Klemm-Kontakte 53 durch den Trennkontakt 43 verbunden sind und durch Einstecken des Schutzsteckers 1 getrennt werden. Außerhalb der Anschlußleiste 20 ist, wie in Fig. 1 dargestellt, eine Erdschiene 44 angeordnet, die längsverlaufend neben der Anschlußleiste 20 angeordnet ist. Der Schutzstecker 1 wird von oben mittig in die Anschlußleiste 20 eingesteckt, wobei die Steckerzunge 5 des Schutzsteckers 1 in den Trennkontakt 43 eingesteckt ist. Die beidseitig auf der Steckerzunge 5 angeordneten Leiterbahnen 10 sind somit mit dem Trennkontakt 43 elektrisch verbunden. Die Steckerzunge 5 weist auf jeder Seite zwei nebeneinanderliegende Leiterbahnen 10 auf, so daß eine Doppelader a, b durch einen Schutzstecker 1 geschützt wird. Nach dem Einstecken des Schutzsteckers 1 in die Anschlußleiste 20 ist auch der Gabelkontakt 42 des Erdkontaktes 40 des Schutzsteckers 1 mit der Erdschiene 44 verbunden, da die Erdschiene 44 in den Gabelkontakt 42 eingesteckt ist.

Nachfolgend wird anhand der Figuren der Überspannungsfall näher erläutert. Im Überspannungsfall fließt der Strom von der Kabelader a über den Schneid-Klemm-Kontakt 53 zum Trennkontakt 43 und über die Leiterbahnen 10 der Steckerzunge 5 zum Anschlußpunkt E, wenn die Leiterplatte 4 gemäß Fig. 10 eingesetzt ist. Vom Anschlußpunkt E fließt der Strom durch das Anschlußbein 23, durch die Stromsicherung 8, durch das Anschlußbein 24 zum Anschlußpunkt C.

Vom Anschlußpunkt C über die Leiterbahn 10 zum Anschlußpunkt D, an dem das Anschlußbein 26 des Spannungsbegrenzers 7 angeschlossen ist. Der Strom fließt nun durch den Spannungsberenzer 7 zum Anschlußbein 27 und von dort über die Klammer 33 und der Kontaktzunge 39 zum Erdkontakt 40, dessen Gabelkontakt 42 mit der Erdschiene 44 elektrisch verbunden ist. Der Strom wird über die Erdschiene 44 auf Erde geleitet.

Während dieses Vorganges des dauerhaften Stromflusses durch den Spannungsbegrenzer 7 entsteht Wärme, die zum Schmelzen des Schmelzelementes 36 führt. Nach Schmelzen des Schmelzelements 36 berühren die federnden Kontaktelemente 37 der Klammer 30 die Anschlußbeine 25 und 26 des Spannungsbegrenzers 7 und schließen somit den Spannungsbegrenzer 7 kurz, wie es auch im Schaltungsbild gemäß Figur 10 dargestellt ist. Die Überspannung wird somit direkt über den Anschlußpunkt C auf Erde 44 geleitet. Das Schmelzelement 36 dient somit als Thermoschutz. Für die Kabelader b funktioniert der Stromfluß in ähnlicher Weise über den Schneid-Klemm-Kontakt 53 zum Trennkontakt 43, über die Leiterbahn 10 der Steckerzunge 5 zum Anschlußpunkt F, durch die Stromsicherung 9 zum Anschlußpunkt A, über die Leiterbahn 10 zum Anschlußpunkt B, der mit dem Anschlußbein 25 des Spannungsbegrenzers 7 verbunden ist. Der Strom fließt auch hier durch den Spannungsbegrenzer 7 zum Anschlußbein 27 und von dort über die Klammer 33 und der Kontaktzunge 39 zum Erdkontakt 40 und zur Erdschiene 44.

Wird die zweite Leiterplatte 4a verwendet, bei der der Stromschutz auf der Amtsseite angeordnet ist, so wird der Stromfluß der Stromsicherungen 8,9 bei hohen Strömen und bei kleinen Spannungen unterbrochen; in diesem Fall spricht der Spannungsbegrenzer 7 nicht an.

Wie in der Figur 2 dargestellt ist, ist das Gehäuse 2 des Schutzsteckers 1 an einer Schmalseite 11 beidseitig mit Aussparungen 13 und an der anderen Schmalseite 12 mit stufenförmigen Freimachungen 14 versehen. Durch die Aussparungen 13 sind nach dem Ziehen eines Schutzsteckers 1 aus einer Reihe von mehreren nebeneinander dicht an dicht angeordneten Schutzsteckern 1 die an den Schneid-Klemm-Kontakten 53 angeschlossenen Kabeladern a,b zugänglich. Der durch Ziehen des Schutzsteckers 1 vorhandene Freiraum 6 ist so groß, daß ein nicht dargestelltes Werkzeug die Kabeladern ab ohne Behinderung anschließen kann. Durch die stufenförmigen Freimachungen 14 ist eine raumsparende Anordnung von zwei in die Anschlußleiste 20 entgegengesetzt eingesteckten Schutzsteckern 1 erreicht.

An der Oberseite 46 des Gehäuses 2 sind insgesamt fünf Gehäuseöffnungen 47 bis 51 vorgesehen, die zum Einstecken einer nicht dargestellten Prüfspitze eines Prüfsteckers dienen.

Die Gehäuseöffnung 47 dient als Zugang für die a-Ader, die Gehäuseöffnung 48 für die a′-Ader, die Gehäuseöffnung 49 für die b-Ader, die Gehäuseöffnung 50 für die b′-Ader und die Gehäuseöffnung 51 dient als Zugang zum Erdpotential.

## Patentansprüche

1. Schutzstecker für Anschlußleisten der Fernmelde- und Datentechnik, bestehend aus einem Gehäuse (2) zur Aufnahme von Schutzelementen, die zur elektrischen Verbindung mit einer Erdschiene (44) und mit einem Trennkontakt (43) an einem Gabelkontakt (42) bzw. an auf eine Steckerzunge (5) aufgebrachten Leiterbahnen (10) angeschlossen sind, wobei der Arbeitskontakt mit Anschlußkontakten (53) für ankommende und abgehende Kabeladern verbunden ist,
**dadurch** **gekennzeichnet**, daß die Steckerzunge (5) aus einer Leiterplatte (4,4a) gebildet ist, die sich in das Gehäuse (2) hineinerstreckt, so daß innerhalb des Gehäuses (2) zwei Gehäuseräume (21,22) gebildet sind,
daß innerhalb der Gehäuseräume (21,22) beidseitig der Leiterplatte (4,4a) Schutzelemente (7,8,9) angeordnet sind und daß die Schutzelemente (7,8,9) über die Leiterbahnen (10) und über durchkontaktierte Anschlußpunkte (A bis F) miteinander verbunden sind.

2. Schutzstecker nach Anspruch 1,
dadurch gekennzeichnet, daß im ersten Gehäuseraum (21) mindestens eine Stromsicherung (8,9) und im zweiten Gehäuseraum (22) ein Spannungsbegrenzer (7) angeordnet sind.

3. Schutzstecker nach Anspruch 1,
dadurch gekennzeichnet, daß die Schutzelemente (7,8,9) mit den Anschlußpunkten (A bis F) elektrisch verbunden sind.

4. Schutzstecker nach Anspruch 1,
dadurch gekennzeichnet, daß der erste Anschlußpunkt (A) mit dem zweiten Anschlußpunkt (B) und der dritte Anschlußpunkt (C) mit dem vierten Anschlußpunkt (D) über die Leiterbahnen (10) verbunden sind.

5. Schutzstecker nach den Ansprüchen 2 und 4,
dadurch gekennzeichnet, daß bei einer ersten Leiterplatte (4) eine erste Stromsicherung (8) mit dem dritten und fünften Anschlußpunkt (C,E) und eine zweite Stromsicherung (9) mit dem ersten und sechsten Anschlußpunkt (A,F) und der Spannungsbegrenzer (7) mit dem zweiten und vierten Anschlußpunkt (B,D) verbunden sind.

6. Schutzstecker nach den Ansprüchen 2 und 4,
dadurch gekennzeichnet, daß bei einer zweiten Leiterplatte (4a) eine erste Stromsicherung (8) mit dem dritten und fünften Anschlußpunkt (C,E) und eine zweite Stromsicherung (9) mit dem ersten und sechsten Anschlußpunkt (A,F) und der Spannungsbegrenzer (7) mit dem zweiten und vierten Anschlußpunkt (B,D) verbunden sind.

7. Schutzstecker nach Anspruch 1,
dadurch gekennzeichnet, daß das Gehäuse (2) an einer Schmalseite (11) beidseitig mit Aussparungen (13) und an der anderen Schmalseite (12) mit stufenförmigen Freimachungen (14) versehen ist.

## Claims

1. A protection connector for a connecting block of the communication and data technique, comprising a housing (2) for receiving protection elements connected to a fork contact (42) or to circuits tracks (10) provided on a connector tongue (5), resp., for establishing an electrical connection with an earth rail (44) and with a disconnect contact (43), the operating contact being connected with terminal contacts (53) for incoming and outgoing cable wires, characterised by that the connector tongue (5) is formed of a printed-circuit board (4, 4a) extending into the housing (2), so that two housing spaces (21, 22) are formed within the housing (2), that protection elements (7, 8, 9) are disposed within the housing spaces (21, 22) on both sides of the printed-circuit board (4, 4a), and that the protection elements (7, 8, 9) are connected with each other over the circuit tracks (10) and over through-contacted terminal points (A to F).

2. A protection connector according to claim 1, characterised by that in the first housing space (21) is provided at least one current protection device (8, 9), and in the second housing space (22) is provided a voltage limiter (7).

3. A protection connector according to claim 1, characterised by that the protection elements (7, 8, 9) are electrically connected with the terminal points (A to F).

4. A protection connector according to claim 1, characterised by that the first terminal point (A) is connected with the second terminal point (B) and the third terminal point (C) with the fourth terminal point (D), over the circuit tracks (10).

5. A protection connector according to claims 2 and 4, characterised by that in a first printed-circuit board (4), a first current protection device (8) is connected with the third and fifth terminal points (C, E), and a second current protection device (9) with the first and sixth terminal points (A, F), and the voltage limiter (7) with the second and fourth terminal points (B, D).

6. A protection connector according to claims 2 and 4, characterised by that in a second printed-circuit board (4a), a first current protection device (8) is connected with the third and fifth terminal points (C, E), and a second current protection device (9) with the first and sixth terminal points (A, F), and the voltage limiter (7) with the second and fourth terminal points (B, D).

7. A protection connector according to claim 1, characterised by that the housing (2) is provided at one narrow side (11) on both sides with recesses (13) and at the other narrow side (12) with step-type cutouts (14).

## Revendications

1. Connecteur de protection pour barrette de connexion pour technique de télécommunication et de traitement de données, comprenant un boîtier (2) pour recevoir des éléments de protection qui sont raccordés à un contact à fourche (42) ou à des pistes conductives (10) prévues sur une lame de contact (5) pour la connexion électrique à un rail de mise à la terre (44) et à un contact de séparation (43), le contact de travail étant connecté avec des contacts de connexion (53) pour les connecteurs de câble d'éntrée et de sortie,
caractérisé en ce que la lame de contact (5) est formée d'une carte imprimée (4, 4a), qui s'étend dans le boîtier (2), de sorte que deux espaces de boîtier (21, 22) soient formés au-dedans du boîtier (2),
qu'au-dedans des espaces de boîtier (21, 22) sont disposés des éléments de protection (7, 8, 9) de part et d'autre de la carte imprimée (4, 4a), et
que les éléments de protection (7, 8, 9) sont connectés l'un à l'autre par l'intermédiaire des pistes conductives (10) et par l'intermédiaire de terminaux (A à F) à trous métallisés.

2. Connecteur de protection selon la revendication 1,
caractérisé en ce que dans le premier espace (21) est disposé au moins un dispositif de protection contre les surcourants (8, 9) et dans le deuxième espace de boîtier (22) un limiteur de tension (7).

3. Connecteur de protection selon la revendication 1,
caractérisé en ce que les éléments de protection (7, 8, 9) sont électrique connectés avec les terminaux (A à F).

4. Connecteur de protection la revendication 1,
caractérisé en ce que le premier terminal (A) est connecté avec le deuxième terminal (B) et le troisième terminal (C) avec le quatrième terminal (D) par l'intermédiaire des pistes conductives (10).

5. Connecteur de protection selon les revendications 2 et 4,
caractérisé en ce que lors d'une première carte imprimée (4) un premier dispositif de protection contre les surcourants (8) est connecté avec le troisième et cinquième terminal (C, E) et un deuxième dispositif de protection contre les surcourants (9) avec le premier et sixième terminal (A, F) et le limiteur de tension (7) avec le deuxième et quatrième terminal (B, D).

6. Connecteur de protection selon les revendications 2 et 4,
caractérisé en ce que lors d'une deuxième carte imprimée (4a) un premier dispositif de protection contre les surcourants (8) est connecté avec le troisième et cinquième terminal (C, E) et un deuxième dispositif de protection contre les surcourants (9) avec le premier et sixième terminal (A, F) et le limiteur de tension (7) avec le deuxième et quatrième terminal (B, D).

7. Connecteur de protection selon la revendication 1,
caractérisé en ce que le boîtier (2) est prévu à un petit côté (11) de part de d'autre d'évidements (13) et à l'autre petit côté (12) de découpures à étapes (14).
